# EUROPEAN PATENT APPLICATION

(11) **EP 4 621 429 A1**
(43) Date of publication of application: **24.09.2025**
(21) Application number: 23907792.8
(22) Date of filing: 21.12.2023
(51) Int. Cl.: G01R 31/392, G01R 33/02, G01R 31/52, H01M 10/48

(54) **BATTERY CELL DEFECT DETECTION DEVICE**

(30) Priority: 23.12.2022 KR 20220183577; 20.12.2023 KR 20230187696
(71) Applicant: LG Energy Solution, Ltd., Seoul 07335 (KR)
(72) Inventor: LEE, Hongkyung, Dalseong-gun, Daegu 42988 (KR); LEE, Jong Cheol, Daejeon 34122 (KR); KWON, Bong Keun, Daejeon 34122 (KR); LIM, Jaehwan, Daejeon 34122 (KR); SHIN, Yewon, Dalseong-gun, Daegu 42988 (KR); LEE, Mingyu, Dalseong-gun, Daegu 42988 (KR); KIM, Jinwoong, Daejeon 34122 (KR)
(74) Representative: Goddar, Heinz J.
(86) International application number: PCT/KR2023/021233
(87) International publication number: WO 2024/136509

(57) **Abstract**

An apparatus for detecting defects of a battery cell according to an embodiment of the present disclosure includes: a current application jig that presses and fixes the electrode leads of the battery cell; and a conductive plate disposed on one surface of the battery cell at a position corresponding to the electrode of the battery cell, wherein the conductive plate includes a main body having the same shape as the electrode of the battery cell and having a uniform thickness, wherein a reverse current having a polarity opposite to the current applied to the battery cell is applied to the conductive plate, and wherein the sum of the magnetic fields derived from the current and the reverse current is measured to detect uncancelled magnetic fields appearing at a defective site of the battery cell, thereby detecting the defective site of the battery cell.

## Description

### [TECHNICAL FIELD]

### Cross Citation with Related Application(s)

This application claims the benefit of Korean Patent Application No. 10-2022-0183577 filed on December 23, 2022 and Korean Patent Application No. 10-2023-0187696 filed on December 20, 2023 in the Korean Intellectual Property Office, the disclosures of which are incorporated herein by reference in their entirety.

The present disclosure relates to an apparatus for detecting defects of a battery cell and a method for detecting defects of a battery cell, and more specifically, to an apparatus for detecting defects of a battery cell and a method for detecting defects of a battery cell, which detect the position of defects in a battery cell using magnetic field interference and cancellation.

### [BACKGROUND]

X-ray CT, which is a conventional non-contact, non-destructive analysis method for battery cells, requires a long analysis time, thus making real-time analysis of various defect causes impossible. Further, in order to solve defects of such X-ray CT analysis, studies have been conducted to analyze defects through visualization of the current distribution inside the battery, however, in the measurement of induced magnetic fields through MRI guidance, it was impossible for electromagnetic waves to penetrate battery cells, and it was also difficult to obtain high resolution due to the ferromagnetic material contained in the battery.

Therefore, research has recently been conducted to introduce a magnetic field imaging (MFI) technology to detect defects through changes in the magnetic field formed during charging and discharging of battery cells. However, such magnetic field imaging technology has limitations in detecting noise due to the sensitivity of the magnetic field sensor, and minute changes in the magnetic field at the sub-micro T level in images when applying a high current. In addition, there is a limitation in that additional data processing, such as comparing the average magnetic field intensity for each section between a normal cell and a defective cell, is required, which needs time.

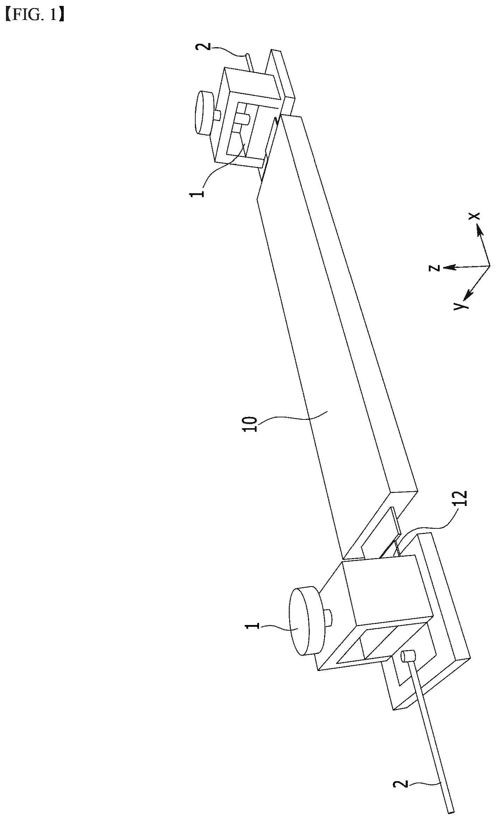

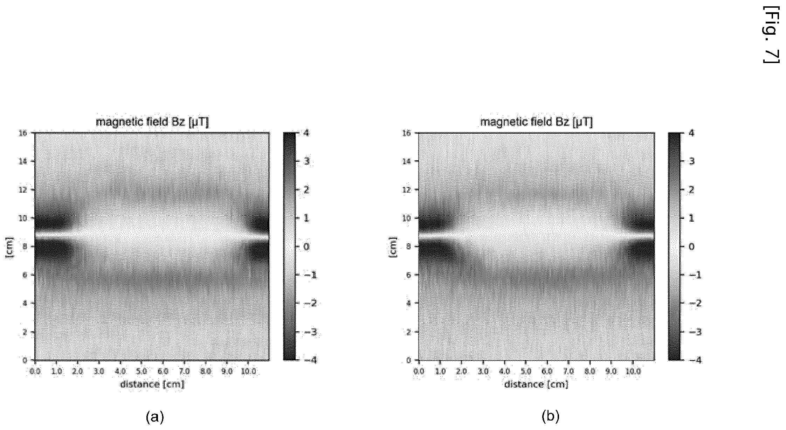

FIG. 1 shows an apparatus for detecting defects of a battery cell according to a prior art. The electrode leads 12 of the battery cells 10 are connected to a pair of current application jigs 1. Current is applied to current-conducing wires 2 connected to each of the current application jigs 1. Accordingly, current flows through the battery cell 10. The magnetic field induced by the current flowing through the battery cell 10 is visualized using a magnetic field imaging(MFI). However, according to such a prior art, there is no significant difference when viewed with the naked eye between the magnetic field image of a normal battery cell and the magnetic field image of a battery cell in which a defect occurs in the electrode plate 11a due to folding of the electrode plate 11a by way of example. FIG. 7 shows a magnetic field image according to a prior art. In FIG. 7, no obvious difference is observed between (a) a normal cell and (b) a defective cell with folded electrode. It took a considerable amount of time to read this at a fine scale level, or in some cases, it was difficult to read.

Therefore, there is a need to develop an improved detection apparatus that can quickly and accurately detect defects in a battery cell.

### [DETAILED DESCRIPTION OF THE INVENTION]

### [Technical Problem]

It is an object of the present disclosure to provide an apparatus for detecting defects of a battery cell and a method for detecting defects of a battery cell. Specifically, among apparatuses that apply magnetic field imaging technology, an apparatus that particularly uses magnetic field interference and cancellation to quickly and accurately detect defects in the battery cell is provided.

However, the technical problems to be solved by embodiments of the present disclosure are not limited to the above-described problems, and can be variously expanded within the scope of the technical idea included in the present disclosure.

### [Technical Solution]

According to one embodiment of the present disclosure, there is provided an apparatus for detecting defects of a battery cell, comprising: a current application jig that presses and fixes the electrode leads of the battery cell; and a conductive plate disposed on one surface of the battery cell at a position corresponding to the electrode of the battery cell, wherein the conductive plate includes a main body having the same shape as the electrode of the battery cell and having a uniform thickness, wherein a reverse current having a polarity opposite to the current applied to the battery cell is applied to the conductive plate, and wherein the sum of the magnetic fields derived from the current and the reverse current is measured to detect uncancelled magnetic fields appearing at a defective site of the battery cell, thereby detecting the defective site of the battery cell.

At the normal site of the battery cell, the magnetic field derived from the current and the magnetic field derived from the reverse current are cancelled each other, so that the sum of the magnetic fields may not be detected, and at the defective site of the battery cell, uncancelled magnetic fields may be detected.

The reverse current applied to the conductive plate may have substantially the same magnitude as the current applied to the battery cell, and flows in the opposite direction.

The apparatus for detecting defects of a battery cell may further comprise a magnetic field measurement unit that is disposed apart from the large area of the battery cell by a prescribed distance.

The reverse current applied to the conductive plate flows in the opposite direction to the current applied to the battery cell; when the distance of the conductive plate from the magnetic field measurement unit is smaller than the distance of the battery cell from the magnetic field measurement unit, the magnitude of the reverse current may be equal to or smaller than the magnitude of the current applied to the battery cell so as to correct a change in intensity of the induced magnetic field corresponding to the distance difference; and when the distance of the conductive plate from the magnetic field measurement unit is greater than the distance of the battery cell from the magnetic field measurement unit, the magnitude of the reverse current may be equal to or greater than the magnitude of the current applied to the battery cell to correct a change in intensity of the induced magnetic field corresponding to the distance difference.

The magnetic field measurement unit may be a magnetic field imaging (MFI) device.

The conductive plate may be disposed to match the large area of the electrode when viewed from top surface, and may be disposed in parallel to the large area of the electrode when viewed from side surface.

The type of defects detected above may include at least one of: a folded portion of the electrode plate of the battery cell, a disconnection portion of the electrode plate, a portion where the electrode active material is unevenly applied to the coated portion of the electrode plate, a disconnection portion of the electrode lead or electrode tab of the battery cell, and a portion where the stacked electrode plates are misaligned.

The conductive plate includes a pair of connection parts that protrude from the main body of the conductive plate so as to be disposed at a position corresponding to the electrode lead of the battery cell, the connection part is formed integrally with the main body, has the same thickness as the main body, and is made of the same material, and the reverse current may be applied to the main body through the connection part.

The battery cell may be configured such that a positive electrode lead is disposed at one end of both ends in the longitudinal direction, and a negative electrode lead is disposed at the other end, and the connection parts may be respectively disposed one by one at both ends of the conductive plate in the longitudinal direction.

The battery cell is configured such that both a positive electrode lead and a negative electrode lead may be disposed at one end of the battery cell, and the pair of connection parts may be all disposed on one end of the main body of the conductive plate corresponding to the one end of the battery cell.

The conductive plate may be made of an electrically conductive material.

The current application jig comprises a current application member that presses the electrode lead and has electrical conductivity, and may further comprise a current-conducting wire connected to the current application member so as to apply current to the battery cell.

The apparatus for detecting defects of a battery cell may further comprise an insulating plate that is disposed under the conductive plate.

According to another embodiment of the present disclosure, there is provided a method for detecting defects of a battery cell, the method comprising the steps of: applying to a conductive plate a reverse current of opposite polarity to the current applied to the battery cell while applying current to the battery cell; measuring the sum of the magnetic fields each derived from the current and the reverse current; and detecting uncancelled magnetic fields appearing at the defective site of the battery cell, thereby detecting a defective site of the battery cell, wherein the conductive plate: comprises a main body having the same shape as the electrode of the battery cell and having a uniform thickness, and may be disposed on one surface of the battery cell at a position corresponding to the electrode of the battery cell.

At the normal site of the battery cell, the magnetic field derived from the current and the magnetic field derived from the reverse current are cancelled each other, so that the sum of the magnetic fields may not be detected, and at the defective site of the battery cell, uncancelled magnetic fields may be detected.

The reverse current applied to the conductive plate may have substantially the same magnitude as the current applied to the battery cell, and flow in the opposite direction.

The magnetic field measurement unit for measuring the sum of the magnetic fields is disposed apart from the large area of the battery cell by a prescribed distance; when the distance of the conductive plate from the magnetic field measurement unit is smaller than the distance of the battery cell from the magnetic field measurement unit, the magnitude of the reverse current may be equal to or smaller than the magnitude of the current applied to the battery cell so as to correct a change in intensity of the induced magnetic field corresponding to the distance difference; and when the distance of the conductive plate from the magnetic field measurement unit is greater than the distance of the battery cell from the magnetic field measurement unit, the magnitude of the reverse current is equal to or greater than the magnitude of the current applied to the battery cell to correct a change in intensity of the induced magnetic field corresponding to the distance difference.

The conductive plate may be disposed to match the large area of the electrode when viewed from top surface, and may be disposed in parallel to the large area of the electrode when viewed from side surface.

The type of defects detected above may include at least one of: a folded portion of the electrode plate of the battery cell, a disconnection portion of the electrode plate, a portion where the electrode active material is unevenly applied to the coated portion of the electrode plate, a disconnection portion of the electrode lead or electrode tab of the battery cell, and a portion where the stacked electrode plates are misaligned.

### [Advantageous Effects]

According to the present disclosure, when applying magnetic field imaging technology to detect defects in a battery cell, magnetic field interference and cancellation can be particularly utilized to quickly and accurately detect defects in the battery cell. In addition, reliability of the quality of the battery cells produced thereby can be ensured.

Effects obtainable from the present disclosure are not limited to the effects mentioned above, and additional other effects not mentioned herein will be clearly understood from the description of the appended claims by those skilled in the art.

### [BRIEF DESCRIPTION OF THE DRAWINGS]

FIG. 1 shows an apparatus for detecting defects of a battery cell according to a prior art.
FIG. 2 schematically shows an apparatus for detecting defects of a battery cell according to an embodiment of the present disclosure.
FIG. 3 shows a conductive plate that is included in the apparatus for detecting defects of a battery cell of FIG. 2, and disposed below the battery cell.
FIG. 4 shows a modification of FIG. 3.
FIG. 5 schematically shows a case where a part of the electrode plate of FIG. 3 is folded.
FIG. 6 shows a magnetic field image measured by the apparatus for detecting defects of a battery cell of FIG. 2.
FIG. 7 shows a magnetic field image according to a comparative example corresponding to the prior art.
FIG. 8 graphically shows the intensity of the magnetic field due to the position of the battery cell in the embodiment of FIG. 6.
FIG. 9 graphically shows the intensity of the magnetic field due to the position of the battery cell in the comparative example of FIG. 7.
FIG. 10 is a flowchart of a method for detecting defects of a battery cell according to an embodiment of the present disclosure.

### [DETAILED DESCRIPTION OF THE EMBODIMENTS]

Hereinafter, embodiments disclosed in the present specification will be described in detail with reference to the accompanying drawings, however, identical or similar elements are assigned identical reference numerals regardless of reference numerals, and a redundant description thereof will be omitted.

The suffixes "member" and/or "part" of elements used in the description below are assigned or used only in consideration of the ease of description of the specification, and the suffixes themselves do not have meanings or roles distinguished from each other. In addition, a term such as "... member", "... part" described in the specification means a unit for performing at least one function or operation, which can be embodied by hardware, by software, or by a combination of hardware and software.

In the following description of the present disclosure, a detailed description of known functions and configurations incorporated herein will be omitted when it may make the subject matter of the present disclosure unclear. In addition, the accompanying drawings are only for easy understanding of the embodiments disclosed in the present specification, however, the technical idea disclosed herein is not limited by the accompanying drawings and should be construed as including all changes, equivalents and substitutes included in the spirit and scope of the present disclosure.

In this specification, terms such as "include" or "have" are intended to designate that the features, numbers, steps, operations, components, parts, or combinations thereof described in the specification exist, but it should be understood that this does not preclude the existence or addition of one or more other features, numbers, steps, operations, components, parts, or combinations thereof.

Now, an apparatus 100 for detecting defects of a battery cell according to an embodiment of the present disclosure will be described.

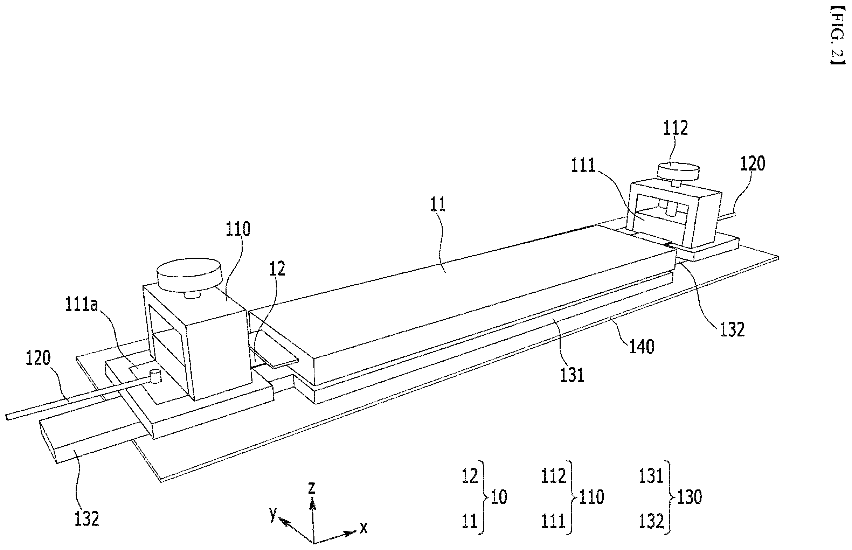

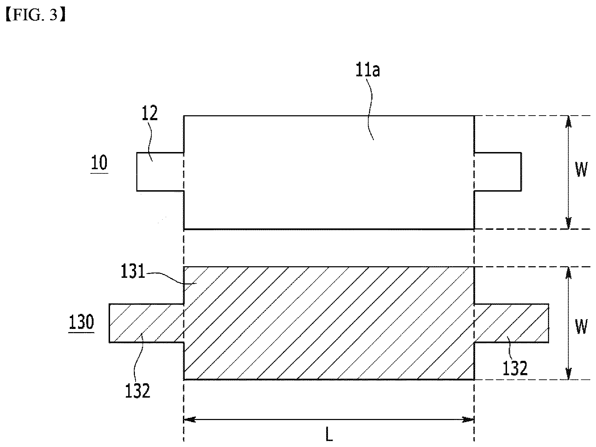

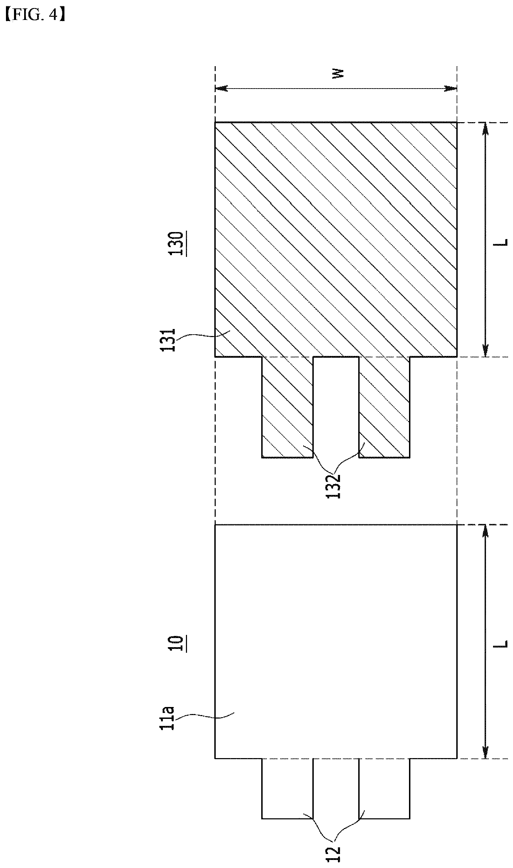

FIG. 2 schematically shows an apparatus 100 for detecting defects of a battery cell according to an embodiment of the present disclosure. FIG. 3 shows a conductive plate that is included in the apparatus for detecting defects of a battery cell of FIG. 2, and disposed below the battery cell. FIG. 4 shows a modification of FIG. 3.

A case in which electrode leads 12 are provided at both ends of the battery cell 10 will be explained as an example.

The apparatus 100 for detecting defects of a battery cell includes a current application jig 110 that is connected to the electrode lead 12 of the battery cell 10 and applies current to the electrode lead 12. The current application jig 110 may be provided one by one for each electrode lead 12. The current application jig 110 includes a current application member 111 that contacts the electrode lead 12 and presses the electrode lead 12. The bottom surface of the current application member 111 may be flat, for example. In addition, the current application member 111 is made of a material with excellent electrical conductivity so that current can flow to the electrode lead 12 through the current application member 111.

The shape and structure of the current application member 111 is not particularly limited, and can be used as long as it has a connection structure capable of electrically conducting to the electrode lead 12, and can apply current uniformly across the width of the electrode lead 12. Examples of a connection structure capable of conducting electricity may include a connection structure for current conductor clip, a bolt fastening structure for wire harness, etc. In addition, if the width of the current application member 111 is relatively narrow while the width of the electrode lead 12 is wide, non-uniform current flow distribution patterns may be observed at the electrode lead 12 and/or the electrode tab site. Thereby, it is preferable that the width of the current applying member 111 is equal to or larger than the width of the electrode lead 12. If necessary, the current application member 111 may press and fix the electrode lead 12.

The upper surface of the current application member 111 includes a fixing member 112 that can press and fix the current application member 111. For example, the fastening member 112 includes an electrically insulating handle, and the lower end of the handle includes a screw-like support part. The end of the support part may contact the upper surface of the current application member 111 and fix the current application member 111. After positioning the electrode lead 12 on the bottom surface of the current application member 111, the current application member 111 is fixed to the end of the support part by turning the handle of the fixing member 112.

A current-conducting wire 120 is connected to the current application member 111, and the current applied from the current-conducting wire 120 is applied to the electrode lead 12 through the electrically conductive current application member 111. The current-conducting wire 120 may be, for example, a conducting wire having electrical conductivity, and more specifically, may be an electric wire. The current-conducting wire 120 includes a positive electrode connection part and a negative electrode connection part. The current application member 111 may further include a plate-shaped electrically conductive member 112a extending outward, and the current-conducting wire 120 may be connected to the electrically conductive member 112a.

Meanwhile, according to an embodiment of the present disclosure, the apparatus 100 for detecting defects of a battery cell includes a conductive plate 130. The conductive plate 130 has a plate shape that can be disposed on one surface of the battery cell 10 at a position corresponding to the electrode of the battery cell, and has electrical conductivity. Referring to FIGS. 2 and 3, the conductive plate 130 includes a plate-shaped main body 131 and a pair of electrically conductive connection parts 132 that can apply a reverse current to the main body 131. The conductive plate 130 is an electrically conductive material, and it is sufficient if it is made of a material having high electrical conductivity and allowing current to flow, and for example, it may be made of common conductive wire materials such as copper, iron, and aluminum.

The main body 131 is a surface wire. That is, it has a plate shape. More specifically, the main body 131 has a flat shape as a whole. This is to ensure that a reverse current flows uniformly throughout the main body 131 and a magnetic field is uniformly induced, as will be described later.

In addition, the main body 131 of the conductive plate 130 has the same shape as one surface of the main body 11 of the battery cell 10. More precisely, it has the same shape as the electrode plate 11a of the battery cell 10. For reference, in the present disclosure, the electrode of the battery cell 10 is a concept including an electrode plate 11a, an electrode tab, and an electrode lead 12.

FIGS, 3 and 4 illustrate a case where the electrode plate 11a of the battery cell 10 and the main body 131 of the conductive plate 130 have the same shape. The main body 131 is provided so that the length L and width W of the electrode plate 11a and the main body 131 of the conductive plate 130 are equal to each other.

Further, when viewed from above, the main body 131 of the conductive plate 130 may be disposed at the same position as the electrode plate 11a of the battery cell 10. Further, when viewed from the side, the conductive plate 130 (main body 131 of the conductive plate 130) may be disposed in parallel to the electrode plate 11a of the battery cell 10.

If the electrode plate 11a is wrapped with the exterior material of the battery cell 10, for example, while finely adjusting the position of the conductive plate 130, a point is found where the magnetic field is wholly cancelled to show a clear image wholly, and aligned with the electrode plate, and the magnetic field detected at a defective site is intensively measured, thereby detecting the defect.

At this time, the main body 131 of the conductive plate 130 is disposed at the same position as the electrode plate 11a of the battery cell 10, and when a reverse current having substantially the same magnitude (current density) as the current flowing through the electrode plate 11a of the battery cell 10 and flowing in the opposite direction (i.e. current densities having opposite polarity and essentially the same size) is applied to the conductive plate 130, the magnetic field induced from the current flowing through the electrode plate 11a of the battery cell 10 and the magnetic field induced from the reverse current applied to the conductive plate 130 are cancelled each other. That is, the magnetic field induced from the current flowing through the electrode plate 11a of the battery cell 10 and the magnetic field induced from the reverse current applied to the conductive plate 130 have the same magnitude, but are generated in opposite directions.

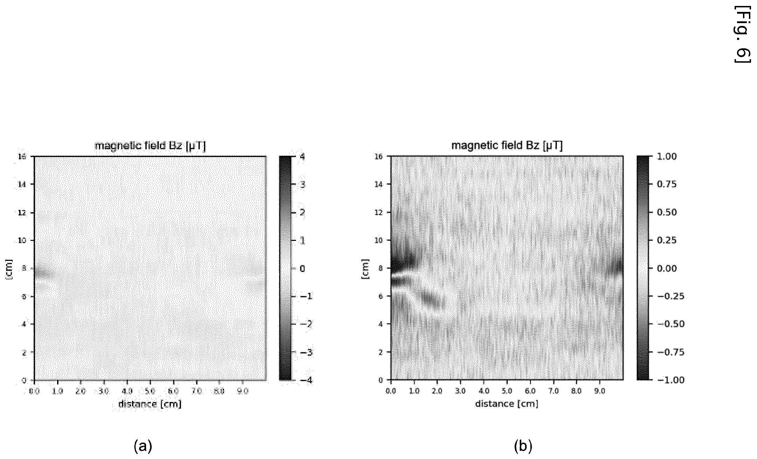

That is, in the case of a normal cell, the magnetic field induced from the current flowing through the electrode plate 11a of the battery cell 10 and the magnetic field induced from the reverse current applied to the conductive plate 130 are cancelled each other. Therefore, when visualized with magnetic field imaging (MFI), the magnetic field is not detected, as shown on the left side of FIG. 6 (FIG. 6(a)). Even if it is detected, it is detected within the acceptable level of the error range.

If the battery cell 10 is slightly thick, due to the distance difference with the conductive plate 130 disposed under the battery cell 10, an error may occur in the magnitude of the magnetic field induced from the current flowing through the electrode plate 11a of the battery cell 10 and the magnetic field induced from the reverse current applied to the conductive plate 130 when measuring the magnetic field with a magnetic field measurement unit (not shown) disposed near the battery cell 10. In order to reduce this error, the magnitude of the reverse current applied to the conductive plate 130 can be further increased or decreased. For reference, through experiments, it was confirmed that the magnitude of the induced magnetic field is proportional to the amount of current and that the distance decreases linearly.

That is, due to the thickness of the battery cell 10, there may be a difference between the distance of the conductive plate 130 from the magnetic field measurement unit and the distance of the battery cell 10 from the magnetic field measurement unit. Therefore, it is necessary to correct the change (difference value) in the intensity of the induced magnetic field corresponding to such a distance difference.

For reference, the magnetic field measurement unit may be located on the upper surface of the battery cell 10, or may be located on the lower surface than the battery cell 10, based on the large area of the battery cell 10 in FIG. 2. The magnetic field measurement unit is a magnetic field imaging (MFI) device, and can be used if it is capable of measuring and imaging the induced magnetic field and measuring defects in the battery cell 10 by the method described in the present disclosure.

More specifically, when the conductive plate 130 is disposed on the surface of the battery cell 10 facing the magnetic field measurement unit, for example, in the example of FIG. 2, when the magnetic field measurement unit is located on the battery cell 10, and the conductive plate 130 is also disposed on the upper surface of the battery cell 10, a difference in the magnitude of the magnetic field due to the distance deviation between the battery cell 10 and the conductive plate 130 due to the thickness of the battery cell 10 is corrected if the magnitude of the reverse current applied to the conductive plate 130 is equal to or smaller than the magnitude of the current applied to the battery cell 10.

Conversely, when the conductive plate 130 is disposed on the surface opposite to the surface of the battery cell 10 facing the magnetic field measurement unit, for example, in the example of FIG. 2, when the magnetic field measurement unit is located on the battery cell 10, and the conductive plate 130 is disposed on the lower surface of the battery cell 10, a difference in the magnitude of the magnetic field due to a distance deviation between the battery cell 10 and the conductive plate 130 due to the thickness of the battery cell 10 is corrected if the magnitude of the reverse current applied to the conductive plate 130 is equal to or greater than the magnitude of the current applied to the battery cell 10.

In other words, when the distance of the conductive plate 130 from the magnetic field measurement unit is smaller than the distance of the battery cell 10 from the magnetic field measurement unit, the magnitude of the reverse current applied to the conductive plate 130 is equal to or smaller than the magnitude of the current applied to the battery cell 10 so as to correct the change in the intensity of the induced magnetic field corresponding to the distance difference. In more detail, if the change in the intensity of the induced magnetic field corresponding to the distance difference is within an error range, the magnitude of the reverse current and the magnitude of the current may be the same.

Conversely, when the distance of the conductive plate 130 from the magnetic field measurement unit is greater than the distance of the battery cell 10 from the magnetic field measurement unit, the magnitude of the reverse current applied to the conductive plate 130 is equal to or greater than the magnitude of the current applied to the battery cell 10 so as to correct the change in the intensity of the induced magnetic field corresponding to the distance difference. In more detail, if the change in the intensity of the induced magnetic field corresponding to the distance difference is within an error range, the magnitude of the reverse current and the magnitude of the current may be the same.

On the other hand, if there is a defect in the electrode plate 11a of the battery cell 10, such as folding of the electrode plate 11a, the reverse current flows uniformly throughout the main body 131 of the conductive plate 130, so that the magnetic field induced therefrom is also uniform as a whole. However, the magnitude of the induced magnetic field changes in a site where the electrode plate 11a of the battery cell 10 has a defect. For example, the surface of the current collector is exposed at the folded part of the electrode plate 11a, and in this part, a decrease in the magnetic field clearly appears due to the absence of the electrode plate 11a and the active material. In addition, the electric current amount decreases in a site where the active material of the electrode plate 11a is not properly applied to the coated part of the electrode plate 11a, and the magnitude of the induced magnetic field decreases. Thereby, the magnetic field induced in the defective site of the electrode plate 11a of the battery cell 10 is not completely cancelled out by the magnetic field in the opposite direction applied from the current flowing uniformly across the conductive plate 130. Therefore, when measured by a magnetic field measurement unit (not shown) placed near the battery cell 10, uncancelled magnetic fields are clearly detected in a defective site of the electrode plate 11a of the battery cell 10 compared to a normal site, as shown on the right side of FIG. 6 (FIG. 6(b)). Therefore, it is possible to quickly and accurately detect a defective site in the electrode plate 11a of the battery cell 10 compared to the prior art.

The connection part 132 of the conductive plate 130 includes a positive electrode part and a negative electrode part. The connection part 132 of the conductive plate 130 may be disposed at a position corresponding to the positive electrode lead and the negative electrode lead of the battery cell 10. That is, when viewed from above, the connection part 132 of the conductive plate 130 may be provided at the same position as the positive electrode lead and the negative electrode lead of the battery cell 10. Further, the connection part 132 may be formed integrally with the main body 131, or may be coupled with the main body 133. The shape of the connection part 132 is not limited to that shown in FIGS. 2 and 3, and may be any shape that allows current to flow through the main body 131.

In some cases, the connection part 132 may also have a plate shape with the same thickness as the main body 131, and may be made of the same material as the main body 131.

The apparatus 100 for detecting defects of a battery cell may further include an insulating plate 140 disposed under the conductive plate 130. For example, the insulating plate 140 may have a thick plate shape, or may be an insulating film. The insulating plate 140 has electrical insulation properties, and prevents the conductive plate 130 or the battery cell 10 from being short-circuited.

In addition, a magnetic field measurement unit (not shown) may be disposed near the battery cell 10 and spaced apart from the battery cell 10 by a prescribed distance. The magnetic field measurement unit measures the total magnetic field in which the magnetic field induced from the current flowing through the battery cell 10 and the magnetic field induced from the reverse current flowing through the conductive plate 130 interfere or cancel with each other. That is, in regard to the sum of the magnetic field induced from the current flowing through the battery cell 10 and the magnetic field induced from the reverse current flowing through the conductive plate 130, since the induced magnetic fields are in opposite directions, the total magnetic field has a value as a result of the induced magnetic fields in opposite directions canceling or interfering with each other.

The embodiment of FIG. 6 shows a magnetic field image when the magnetic field measurement unit is disposed on the battery cell 10, that is, when it is disposed on the Z-axis (in height direction of the battery cell 10). However, the present disclosure is not limited thereto, and the magnetic field measurement units are disposed on the front or back side of the battery cell 10, that is, on the X-axis (in the longitudinal direction of the battery cell 10), or are disposed on both sides of the battery cell 10, that is, on the Y-axis (in the width direction of the battery cell 10), so the Y-axis component of the induced magnetic field can also be measured.

Moreover, a normal magnetic field measurement unit can be applied as the magnetic field measurement unit. For example, it may be a magnetic field imaging device using magnetic field imaging (MFI) technology. However, the present disclosure is not limited thereto, and it is sufficient if it is a measuring unit capable of detecting a magnetic field and indicating the location of a defect in the battery cell 10.

Meanwhile, the types of defects of the battery cell 10 that can be detected according to the embodiment of the present disclosure are not limited to those set forth above, and various types of defects can be detected. For example, in addition to the folding of the electrode plate 11a, disconnection of the electrode plate 11a (e.g., perforation or tearing, etc.), and defective application of the electrode active material on the coated part of the electrode plate 11a as described above, the point of disconnection of electrode tabs or electrode leads can also be detected. In this case, the connection part 132 of the conductive plate 130 has the same shape as the electrode tab or electrode lead, while it is possible to effectively detect the point of disconnection of the electrode tab or electrode lead when the main body 131 and the connection part 132 of the conductive plate 130 are formed integrally and have the same thickness and the same flatness. Alternatively, misalignment of the plurality of electrode plates 11a stacked inside the battery cell 10 can also be detected. As much as the electrode plates 11a are misaligned, there is a change in the magnetic field induced before the current is applied to the battery cell 10 at the misaligned site, and if this is canceled out by a uniform magnetic field induced from the reverse current applied to the conductive plate 130, the changed magnetic field is clearly detected in the misaligned site.

In the embodiments of FIGS. 2 and 3 described above, an apparatus for detecting defects of the battery cell 10 when a positive electrode lead and a negative electrode lead are separately provided at both ends of the battery cell 10 was described. However, the present disclosure is not limited thereto, and can be modified and changed to match the environment in which the invention is implemented.

For example, referring to FIG. 4, when both the positive electrode lead and the negative electrode lead are provided at one end of the battery cell 10, it can also be implemented by placing the connection part 132 of the conductive plate 130 at a position corresponding to the positive electrode lead and the negative electrode lead of the battery cell 10. That is, when viewed from above, if the connection part 132 of the conductive plate 130 is provided at the same position as the positive electrode lead and the negative electrode lead of the battery cell 10, the current flowing through the electrode plate 11a of the battery cell 10 and the reverse current flowing through the main body 131 of the conductive plate 130 have merely opposite directions, and the flowing patterns are substantially the same, so that the magnetic fields are cancelled each other, and defects in the battery cell 10 can be easily detected.

For reference, in FIGS. 3 and 4, the dotted line shown between the electrode plate 11a and the electrode lead 12 of the battery cell 10 and the dotted line shown between the main body 131 and the connecting part 132 of the conductive plate 130 do not mean a folded part, but is indicated as a dotted line to clarify the division between each component. In addition, it is noted that the electrode tabs are not separately divided in the portion marked as the electrode lead 12.

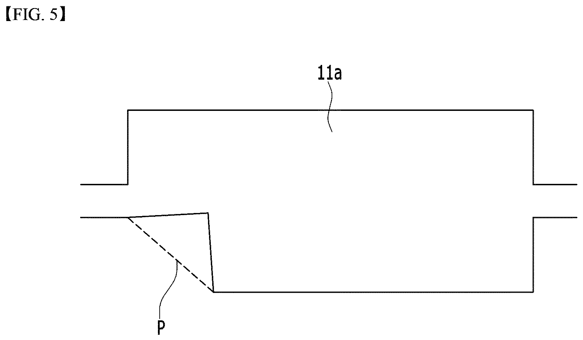

FIG. 5 schematically shows a case where a part of the electrode plate 11a of FIGS. 2 and 3 is folded. FIG. 6 shows a magnetic field image measured by the apparatus 100 for detecting defects of a battery cell of FIG. 2. FIG. 7 shows a magnetic field image according to a comparative example (prior art). In FIGS. 6 and 7, (a) on the left side shows the case of a normal cell, and (b) on the right side shows the case of a cell with an Electrode-folded defect.

The measurement conditions in the embodiment of FIG. 6 and the embodiment of FIG. 7 are the same and are as follows.
- Charging current: 260 mA
- z-distance: 3 mm (distance between battery cell and measurement unit)
- Measurement speed: 100 mm/min
- 3rd scan mean data
- Image resolution: 2.5 * 0.0646 mm²

In addition, in the embodiment of FIG. 6, as described above, a charging current of the same magnitude is applied to the conductive plate 130, but a current in the opposite direction to the current applied to the battery cell 10 is applied.

It can be seen that a change in the magnetic field clearly appears in the magnetic field image on the right side of FIG. 6, i.e., in FIG. 6(b), so as to coincide with the partially folded part (P) of the electrode plate 11a in FIG. 5. On the other hand, in FIG. 7 according to the comparative example, no clear difference is seen between (a) the case of a normal cell and (b) the case of a defective cell with folded electrode. Therefore, it can be seen that there is a limit to visually clearly distinguishing the position of a defect.

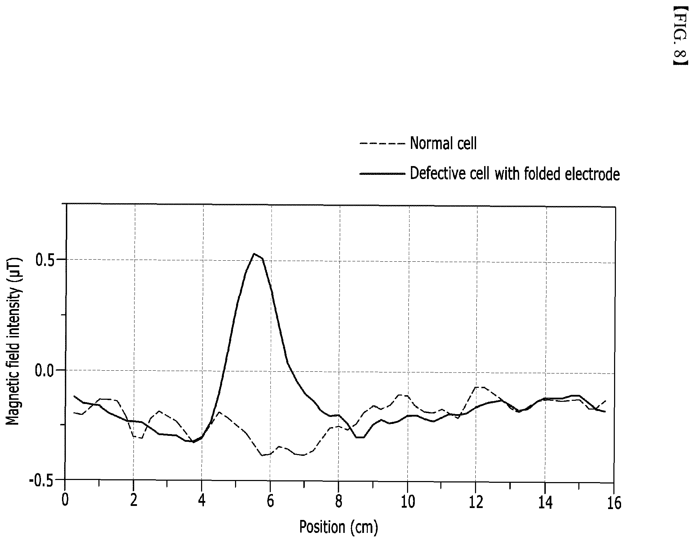

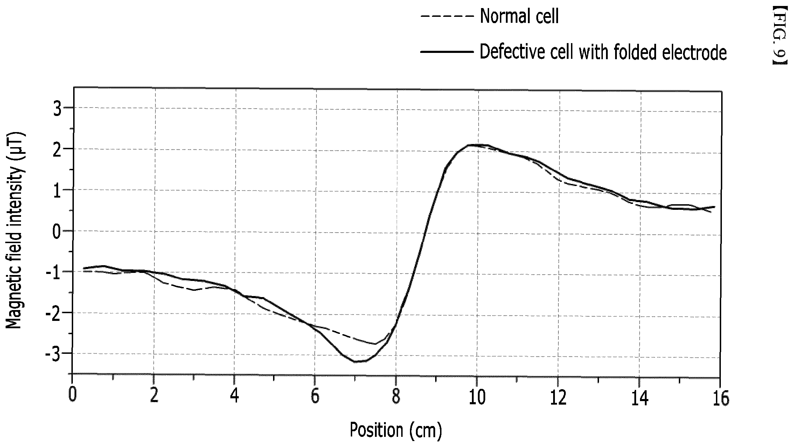

FIG. 8 graphically shows the intensity of the magnetic field due to the position of the battery cell 10 in the embodiment of FIG. 6. FIG. 9 graphically shows the intensity of the magnetic field due to the position of the battery cell 10 in the comparative example of FIG. 7. In the graph of FIG. 8 according to the embodiment of FIG. 6, the difference in the strength of the magnetic field measured between the defective cell with folded electrode and the normal cell clearly appears at the defective site. On the other hand, in the graph of FIG. 9 according to the embodiment of FIG. 7, the trends of the graph regarding the intensity of the magnetic field measured between the defective cell with folded electrode and the normal cell are similar, so the defect does not appear clearly.

Next, a method for detecting defects of a battery cell according to an embodiment of the present disclosure will be described.

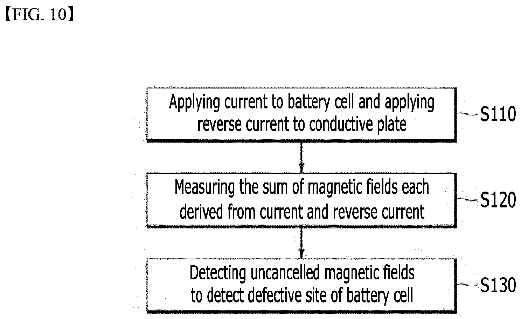

FIG. 10 is a flowchart of a method for detecting defects of a battery cell according to an embodiment of the present disclosure.

Referring to FIG 10, a method for detecting defects of a battery cell comprises a step (S110) of applying to a conductive plate a reverse current of opposite polarity to the current applied to the battery cell while applying current to the battery cell; a step (S120) of measuring the sum of the magnetic fields derived from the current applied to the battery cell and the reverse current applied to the conductive plate; and a step (S130) of detecting uncancelled magnetic fields appearing at the defective site of the battery cell, thereby detecting a defective site of the battery cell.

As described above with reference to FIGS. 2 to 4 , the conductive plate 130 has a plate shape that can be placed on one surface of the battery cell 10 at a position corresponding to the electrode of the battery cell 10, and has electrical conductivity. The conductive plate 130 is disposed to match the large area of the electrode of the battery cell 10 when viewed from a top face, and is disposed in parallel to the large area of the electrode of the battery cell 10 when viewed from a side face.

The reverse current applied to the conductive plate 130 has substantially the same magnitude as the current applied to the battery cell 10, and flows in the opposite direction.

At the normal site of the battery cell 10, the magnetic field induced from the current applied to the battery cell 10 and the magnetic field induced from the reverse current applied to the conductive plate 130 are cancelled each other, so that the sum of the magnetic fields is not detected.

On the other hand, at the defective site of the battery cell, the magnitude of the current applied to the battery cell 10 and the magnitude of the reverse current applied to the conductive plate 130 are different, and therefore, the magnetic field induced from the current applied to the battery cell 10 and the magnetic field induced from the reverse current applied to the conductive plate 130 are not completely canceled out, and uncancelled magnetic fields are detected.

As described above, the magnetic field measurement unit is disposed apart from the large area of the battery cell 10 by a prescribed distance. At this time, due to the thickness of the battery cell 10, there may be a difference between the distance of the conductive plate 130 from the magnetic field measurement unit and the distance of the battery cell 10 from the magnetic field measurement unit. Therefore, it is necessary to correct the change (difference value) in the intensity of the induced magnetic field corresponding to such a distance difference.

More specifically, when the distance of the conductive plate 130 from the magnetic field measurement unit is smaller than the distance of the battery cell 10 from the magnetic field measurement unit, the magnitude of the reverse current is equal to or smaller than the magnitude of the current applied to the conductive plate 130 so as to correct a change in intensity of the induced magnetic field corresponding to the distance difference. In more detail, if the change in intensity of the induced magnetic field corresponding to the distance difference is within the error range, the magnitude of the reverse current and the magnitude of the current may be the same.

On the other hand, when the distance of the conductive plate 130 from the magnetic field measurement unit is greater than the distance of the battery cell 10 from the magnetic field measurement unit, the magnitude of the reverse current applied to the conductive plate 130 is equal to or greater than the magnitude of the current applied to the battery cell 10 so as to correct the change in the intensity of the induced magnetic field corresponding to the distance difference. In more detail, if the change in the intensity of the induced magnetic field corresponding to the distance difference is within an error range, the magnitude of the reverse current and the magnitude of the current may be the same.

The type of defects of the battery cell includes at least one of: a folded portion of the electrode plate 11a of the battery cell 10, a disconnection portion of the electrode plate 11a, a portion where the electrode active material is unevenly applied to the coated portion of the electrode plate 11a, a disconnection portion of the electrode lead 12 or electrode tab of the battery cell 10, and a portion where the stacked electrode plates 11a are misaligned.

In addition, a more detailed description of the method for detecting defects of a battery cell overlaps with the description of the apparatus for detecting defects of a battery cell described above in FIGS. 2 to 9 and therefore, refer to those described above with reference to FIGS. 2 to 9.

When detecting defects of the battery cell 10 using the apparatus 100 for detecting defects of a battery cell and the method for detecting defects of a battery cell according to the present disclosure, it is possible to quickly detect a defective site as compared to the prior art. At the same time, it is possible to more accurately determine the defective site. Thereby, reliability of the quality of the produced battery cells can be secured.

Although the invention has been described in detail above with reference to preferred embodiments thereof, it will be appreciated by those skilled in the art that the scope of the present disclosure is not limited thereto, and various modifications and improvements can be made in these embodiments without departing from the principles and sprit of the invention, the scope of which is defined in the appended claims and their equivalents.

### [Description of Reference Numerals]

10: battery cell
11: main body
11a: electrode plate
12: electrode lead
100: apparatus for detecting defects of battery cell
110: current application jig
111: current application member
112: fixed member
120: current-conducing wire
130: conductive plate
131: main body
132: connection part
140: insulating plate

## Claims

1. An apparatus for detecting defects of a battery cell, comprising:
a current application jig that presses and fixes the electrode leads of the battery cell; and
a conductive plate disposed on one surface of the battery cell at a position corresponding to the electrode of the battery cell,
wherein the conductive plate includes a main body having the same shape as the electrode of the battery cell and having a uniform thickness,
wherein a reverse current having a polarity opposite to the current applied to the battery cell is applied to the conductive plate, and
wherein the sum of the magnetic fields derived from the current and the reverse current is measured to detect uncancelled magnetic fields appearing at a defective site of the battery cell, thereby detecting the defective site of the battery cell.

2. The apparatus for detecting defects of a battery cell according to claim 1, wherein:
at the normal site of the battery cell, the magnetic field derived from the current and the magnetic field derived from the reverse current are cancelled each other, so that the sum of the magnetic fields is not detected, and
at the defective site of the battery cell, uncancelled magnetic fields are detected.

3. The apparatus for detecting defects of a battery cell according to claim 1, wherein:
the reverse current applied to the conductive plate has substantially the same magnitude as the current applied to the battery cell, and flows in the opposite direction.

4. The apparatus for detecting defects of a battery cell according to claim 1,
further comprising a magnetic field measurement unit that is disposed apart from the large area of the battery cell by a prescribed distance.

5. The apparatus for detecting defects of a battery cell according to claim 4, wherein:
the reverse current applied to the conductive plate flows in the opposite direction to the current applied to the battery cell,
when the distance of the conductive plate from the magnetic field measurement unit is smaller than the distance of the battery cell from the magnetic field measurement unit, the magnitude of the reverse current is equal to or smaller than the magnitude of the current applied to the battery cell so as to correct a change in intensity of the induced magnetic field corresponding to the distance difference, and
when the distance of the conductive plate from the magnetic field measurement unit is greater than the distance of the battery cell from the magnetic field measurement unit, the magnitude of the reverse current is equal to or greater than the magnitude of the current applied to the battery cell to correct a change in intensity of the induced magnetic field corresponding to the distance difference.

6. The apparatus for detecting defects of a battery cell according to claim 4, wherein:
the magnetic field measurement unit is a magnetic field imaging (MFI) device.

7. The apparatus for detecting defects of a battery cell according to claim 1, wherein:
the conductive plate:
is disposed to match the large area of the electrode when viewed from top surface, and
is disposed in parallel to the large area of the electrode when viewed from side surface.

8. The apparatus for detecting defects of a battery cell according to claim 1, wherein:
the type of defects detected above includes at least one of: a folded portion of the electrode plate of the battery cell, a disconnection portion of the electrode plate, a portion where the electrode active material is unevenly applied to the coated portion of the electrode plate, a disconnection portion of the electrode lead or electrode tab of the battery cell, and a portion where the stacked electrode plates are misaligned.

9. The apparatus for detecting defects of a battery cell according to claim 1, wherein:
the conductive plate includes a pair of connection parts that protrude from the main body of the conductive plate so as to be disposed at a position corresponding to the electrode lead of the battery cell,
the connection part is formed integrally with the main body, has the same thickness as the main body, and is made of the same material, and
the reverse current is applied to the main body through the connection part.

10. The apparatus for detecting defects of a battery cell according to claim 9, wherein:
the battery cell is configured such that a positive electrode lead is disposed at one end of both ends in the longitudinal direction, and a negative electrode lead is disposed at the other end, and
the connection parts are respectively disposed one by one at both ends of the conductive plate in the longitudinal direction.

11. The apparatus for detecting defects of a battery cell according to claim 9, wherein:
the battery cell is configured such that both a positive electrode lead and a negative electrode lead are disposed at one end of the battery cell, and
the pair of connection parts are all disposed on one end of the main body of the conductive plate corresponding to the one end of the battery cell.

12. The apparatus for detecting defects of a battery cell according to claim 1, wherein:
the conductive plate is made of an electrically conductive material.

13. The apparatus for detecting defects of a battery cell according to claim 1, wherein:
the current application jig comprises a current application member that presses the electrode lead and has electrical conductivity, and
further comprise a current-conducting wire connected to the current application member so as to apply current to the battery cell.

14. The apparatus for detecting defects of a battery cell according to claim 1,
further comprising an insulating plate that is disposed under the conductive plate.

15. A method for detecting defects of a battery cell, the method comprising the steps of:
applying to a conductive plate a reverse current of opposite polarity to the current applied to the battery cell while applying current to the battery cell;
measuring the sum of the magnetic fields each derived from the current and the reverse current; and
detecting uncancelled magnetic fields appearing at the defective site of the battery cell, thereby detecting a defective site of the battery cell,
wherein the conductive plate:
comprises a main body having the same shape as the electrode of the battery cell and having a uniform thickness, and
is disposed on one surface of the battery cell at a position corresponding to the electrode of the battery cell.

16. The method for detecting defects of a battery cell according to claim 15, wherein:
at the normal site of the battery cell, the magnetic field derived from the current and the magnetic field derived from the reverse current are cancelled each other, so that the sum of the magnetic fields is not detected, and
at the defective site of the battery cell, uncancelled magnetic fields are detected.

17. The method for detecting defects of a battery cell according to claim 15, wherein:
the reverse current applied to the conductive plate has substantially the same magnitude as the current applied to the battery cell, and flows in the opposite direction.

18. The method for detecting defects of a battery cell according to claim 15, wherein:
the magnetic field measurement unit for measuring the sum of the magnetic fields is disposed apart from the large area of the battery cell by a prescribed distance,
when the distance of the conductive plate from the magnetic field measurement unit is smaller than the distance of the battery cell from the magnetic field measurement unit, the magnitude of the reverse current is equal to or smaller than the magnitude of the current applied to the battery cell so as to correct a change in intensity of the induced magnetic field corresponding to the distance difference, and
when the distance of the conductive plate from the magnetic field measurement unit is greater than the distance of the battery cell from the magnetic field measurement unit, the magnitude of the reverse current is equal to or greater than the magnitude of the current applied to the battery cell to correct a change in intensity of the induced magnetic field corresponding to the distance difference.

19. The method for detecting defects of a battery cell according to claim 15, wherein:
the conductive plate:
is disposed to match the large area of the electrode when viewed from top surface, and
is disposed in parallel to the large area of the electrode when viewed from side surface.

20. The method for detecting defects of a battery cell according to claim 15, wherein:
the type of defects detected above includes at least one of: a folded portion of the electrode plate of the battery cell, a disconnection portion of the electrode plate, a portion where the electrode active material is unevenly applied to the coated portion of the electrode plate, a disconnection portion of the electrode lead or electrode tab of the battery cell, and a portion where the stacked electrode plates are misaligned.
